(19) Europäisches Patentamt
European Patent Office
Office européen des brevets

(11) **EP 2 901 167 B1**

(12) **FASCICULE DE BREVET EUROPEEN**

(45) Date de publication et mention
de la délivrance du brevet:
**27.11.2019 Bulletin 2019/48**

(51) Int Cl.:
***G01R 31/02*** *(2006.01)*

(21) Numéro de dépôt: **13779283.4**

(22) Date de dépôt: **20.09.2013**

(86) Numéro de dépôt international:
**PCT/FR2013/052188**

(87) Numéro de publication internationale:
**WO 2014/049247 (03.04.2014 Gazette 2014/14)**

(54) **PROCEDE ET DISPOSITIF DE DETERMINATION DE LA POSITION D'UN DEFAUT D'ISOLEMENT**

VERFAHREN UND VORRICHTUNG ZUR BESTIMMUNG DER POSITION EINES ISOLATIONSFEHLERS

METHOD AND DEVICE FOR DETERMINING THE LOCATION OF AN INSULATION FAULT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.09.2012 FR 1259155**

(43) Date de publication de la demande:
**05.08.2015 Bulletin 2015/32**

(73) Titulaire: **Renault S.A.S.**
**92100 Boulogne-Billancourt (FR)**

(72) Inventeurs:
• **PEUCHANT, Yves**
**F-75014 Paris (FR)**
• **LE VOURCH, Yves**
**F-78150 Le Chesnay (FR)**

(56) Documents cités:
**EP-A1- 1 265 076      EP-A1- 1 857 825**

EP 2 901 167 B1

## Description

### Domaine technique

La présente invention se rapporte à un procédé de détermination des caractéristiques d'un défaut d'isolement entre un circuit électrique incluant une batterie d'accumulateurs dans un véhicule automobile et la masse du véhicule, lorsque ce circuit doit être isolé de la masse. Elle concerne également un dispositif pour mettre en oeuvre ce procédé.

### Etat de la technique

Sur un véhicule dont une part ou la totalité de la traction est assurée par un ou plusieurs moteurs électriques, tel qu'un véhicule électrique ou hybride, deux réseaux électriques cohabitent :

- le réseau électrique de la chaine de traction ;
- le réseau électrique d'alimentation des consommateurs de la voiture.

Les normes de sécurité peuvent imposer que les deux circuits soient isolés, en particulier le réseau d'alimentation de la chaîne de traction dont la tension peut être élevée. L'isolation entre ces 2 réseaux doit être supérieure à un seuil prédéterminé. Le règlement n°100 de l'UNECE impose par exemple une isolation supérieure à $100\Omega/V$.

Pour une batterie de véhicule électrique délivrant 400V, la résistance d'isolement (notée Ri) entre les deux réseaux doit être supérieure à 40 kΩ.

On peut prévoir des systèmes embarqués d'estimation des résistances d'isolement sur véhicule, pour fournir une estimation de la valeur de la résistance d'isolement entre le réseau de traction et le châssis véhicule. Le règlement n°100 propose à l'annexe 4 une méthode de d'évaluation de la résistance d'isolement selon laquelle on mesure la tension entre chacune des bornes de la batterie et le châssis du véhicule. Supposons que la tension V1 ainsi mesurée soit la plus élevée sur la première borne. On connecte alors un circuit de mesure comportant une première branche résistive de valeur R0 entre la première borne de la batterie et la masse et on réalise une mesure de tension V2 aux bornes de la première branche résistive. La résistance d'isolement est alors estimée par la formule : $Ri=R0.(V1-V2)/V2$

Si le défaut d'isolement se situe à l'intérieur de la batterie, cette méthode n'en fournit pas d'indicateur de la position. Or, une telle indication serait utile pour diagnostiquer précisément l'origine d'un éventuel défaut.

Le document US 2005/0264264 montre un système permettant de localiser un éventuel défaut d'isolement à l'intérieur d'une batterie d'accumulateurs. Cependant, ce système nécessite une connexion physique entre chaque élément de la batterie.

Les documents EP1857825A1 et EP1265076A1 de l'état de la technique sont également pertinents.

L'invention vise donc à fournir un système et un procédé de détermination par des moyens non intrusifs des caractéristiques d'un défaut d'isolement entre un circuit électrique incluant une batterie d'accumulateurs dans un véhicule automobile et la masse du véhicule.

### Description de l'invention

Un procédé de détermination de la position d'un défaut d'isolement selon l'invention est défini dans la revendication 1.

Grâce à l'invention, on est en mesure de déterminer la position d'un éventuel défaut d'isolement en réalisant simplement des mesures entre les bornes de la batterie et la masse. En connectant la branche résistive entre l'une des bornes et la masse, on ferme un circuit électrique faisant intervenir la résistance du défaut d'isolement. Un courant électrique circule dans ce circuit en fonction d'une part de la résistance du défaut d'isolement et d'autre part de la tension génératrice dans ce circuit. En fonction de la position du défaut d'isolement la tension génératrice est une part de la tension de la batterie. En connectant les moyens de mesure à l'autre borne, la tension génératrice est inversée par rapport au circuit précédent, et la valeur absolue de la tension est complémentaire à la part de tension de la batterie. Les deux mesures permettent d'établir deux équations desquelles on peut extraire les deux inconnues que sont la résistance et la position du défaut d'isolement.

Selon un perfectionnement, on réalise une troisième mesure similaire à la première mesure en connectant en outre une deuxième branche résistive en parallèle à la première branche résistive, et on déduit du rapport entre la première et la troisième mesure une valeur de la résistance du défaut d'isolement. La connexion de la deuxième branche résistive modifie les conditions de fonctionnement qui déterminent le courant mesuré par les moyens de mesure. Ici également, les deux mesures permettent d'établir deux équations qui permettent d'accéder à la résistance d'isolement.

Selon d'autres dispositions

- on place en outre une résistance de protection connectée entre la première branche et la borne de la batterie. On prévient ainsi les conséquences d'un court-circuit accidentel entre les différents connecteurs vers les bornes de la batterie.
- la première branche résistive comporte deux résistances en série et une source de tension d'adaptation, la mesure représentative du courant dans la première branche résistive est réalisée par une mesure de tension entre la masse et un point intermédiaire entre les deux résistances. Avec les deux résistances en série, on divise la tension entre la masse et borne, ce qui permet d'utiliser un instrument de mesure de la tension ordinaire, fréquemment utilisé dans l'environnement d'un véhicule.
- la position de la résistance d'isolement, exprimée par un coefficient de proportion $\alpha$ de tension entre la deuxième et la première borne, est calculée par l'expression :

$$\alpha = \frac{1}{1 - \dfrac{U_{A1}}{U_{A2}}}$$

avec

$$\begin{cases} U_{A1} = U_{a1} - k_a U_1 \\ U_{A2} = U_{a2} - k_a U_1 \end{cases}$$

où $U_{a1}$ et $U_{a2}$ représentent respectivement la première et la deuxième mesure, $k_a$ un coefficient représentatif des moyens de mesure et proche de 1 et $U_1$ la tension d'adaptation. Le coefficient ka prend la place d'un terme qui comprend la résistance d'isolement. Cependant, en exprimant ce terme pour une résistance correspondant à une limite admissible, on constate que l'erreur introduite en lui donnant une valeur fixe est faible, en particulier lorsque la véritable valeur de la résistance d'isolement est proche de la valeur limite autorisée.

L'invention a aussi pour objet un dispositif de détermination d'un défaut d'isolement comme défini dans la revendication 6. Les moyens de commutation permettent de modifier directement le raccordement aux bornes sans intervenir manuellement. De plus, les moyens de commutation peuvent être pilotés de telle manière que le procédé de mesure soit mis en oeuvre de manière automatique.

Selon d'autres caractéristiques :

- les moyens de mesure comportent en outre une deuxième branche résistive et de deuxièmes moyens de commutation pour connecter sélectivement la deuxième branche résistive en parallèle à la première branche résistive entre la masse et les premiers moyens de commutation.
- les moyens de mesure comportent au moins une résistance de protection destinée à être connectée à la borne de la batterie.
- la première branche résistive comporte deux résistances et une source de tension d'adaptation en série, les moyens de mesure comportant un voltmètre pour mesurer une tension entre la masse et un point intermédiaire entre les deux résistances.

Selon une disposition particulière, les moyens de mesure sont agencés pour estimer la valeur de la résistance d'isolement $R_i$ par l'expression :

$$R_i = R_3 \frac{\dfrac{U_{A1}}{U_{B1}}\left(R_1 + R_{eq} + R_2\right) - \left(R_1 + \dfrac{R_5}{2}\right)\left(\dfrac{R_2 + R_3}{R_3}\right) - R_2}{R_1 + R_{eq} + R_3\left(1 - \dfrac{U_{A1}}{U_{B1}}\right)}$$

si $U_{B1}$ est non nulle, ou par l'expression

$$R_i = R_3 \frac{\dfrac{U_{A2}}{U_{B2}}(R_1 + R_{eq} + R_2) - (R_1 + R_{eq})\left(\dfrac{R_2 + R_3}{R_3}\right) - R_2}{R_1 + R_{eq} + R_3\left(1 - \dfrac{U_{A2}}{U_{B2}}\right)}$$

si $U_{B2}$ est non nulle, avec

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

où $U_{a1}$, $U_{a2}$, $U_{b1}$, et $U_{b2}$ représentent respectivement la première, la deuxième, la troisième mesure et la quatrième mesure, $k_a$ et $k_b$ des coefficients représentatifs des moyens de mesure et proche de 1, $U_1$ la tension d'adaptation, $R_2$ la valeur de la résistance de protection, $R_3$ la valeur de la résistance de la deuxième branche, $R_{eq}$ la valeur de la résistance de la première branche entre la masse et le point intermédiaire et $R_1$ la valeur de la résistance de la première branche entre le point intermédiaire et le point de connexion entre la première et la deuxième branche. Comme précédemment pour le terme $k_a$, le coefficient $k_b$ prend la place d'un terme qui comprend la résistance d'isolement.

**Brève description des figures**

L'invention sera mieux comprise et d'autres particularités et avantages apparaîtront à la lecture de la description qui va suivre, la description faisant référence aux dessins annexés parmi lesquels :

- la figure 1 est un schéma électronique d'un dispositif conforme à un mode de réalisation de l'invention ;
- la figure 2 est un schéma du dispositif de la figure 1 tel qu'installé sur un circuit d'alimentation de la chaîne de traction d'un véhicule ;
- la figure 3 est un schéma simplifié du schéma de la figure 2 ;
- les figures 4 à 7 sont des schémas équivalents au schéma de la figure 2 selon différents modes de connexion.

**DESCRIPTION DETAILLEE**

Un dispositif de détermination des caractéristiques d'un défaut d'isolement dans un véhicule automobile conforme à l'invention comporte un contrôleur 18, des résistances et des moyens de commutation. Le dispositif 1 comporte en outre un premier connecteur 11 pour être connecté à une première borne 21 d'une batterie 2 d'accumulateurs, un deuxième connecteur 12 pour être connecter à une deuxième borne 22 de la batterie 2 et un troisième connecteur 13 pour être connecter à la masse 3 électrique du véhicule. La batterie 2 d'accumulateurs est prévue pour alimenter une chaîne de traction du véhicule, non représentée, et être isolée de la masse 3 du véhicule. Le dispositif 1 est prévu pour déterminer quelle est la résistance d'isolement entre la batterie 2 et la masse 3 et si un défaut d'isolement existe, quelle est la position du défaut.

Le dispositif 1 comporte des moyens de mesure comportant des premiers moyens de commutation 14 qui comportent deux optocoupleurs 141, 142 reliés respectivement au premier et au deuxième connecteur 11, 12. Chaque optocoupleur 141, 142 est relié respectivement à une première et une deuxième borne de commande 181, 182 du contrôleur 18 par l'intermédiaire d'une résistance Rsw pour alimenter une diode de commande de l'optocoupleur 141, 142. Chaque optocoupleur 141, 142 est relié d'autre part à une résistance de protection 15 de valeur R2. La mise sous tension de la diode permet de rendre l'optocoupleur passant entre la résistance de protection 15 et le connecteur 11, 12 respectif.

Les deux résistances de protection 15 sont reliées ensemble à un point commun 17. Les moyens de mesure comportent en outre une première branche résistive 16 connectée entre le point commun 17 et la masse 3. La première branche résistive 16 comporte une première résistance 161 de valeur R1 entre le point commun 17 et un point intermédiaire 165, et une deuxième résistance 162 de valeur R5 entre le point intermédiaire 165 et la masse 3. La première branche résistive comporte en outre une troisième résistance 163 également de valeur R5 connectée entre le point intermédiaire 165 et une borne de référence 184 du contrôleur 18. La borne de référence 184 fournit une tension de référence $V_{REF+}$, par exemple de 5V. Une borne d'entrée 185 du contrôleur 18 est reliée au point intermédiaire 165. La borne d'entrée 185 est connectée dans le contrôleur 18 à un voltmètre, non représenté, apte à mesurer une tension comprise entre la masse 3 et $V_{REF+}$.

Les moyens de mesure comportent en outre une deuxième branche résistive 19 et de deuxièmes moyens de commutation pour connecter sélectivement la deuxième branche résistive 19 en parallèle à la première branche résistive 16 entre la masse 3 et les premiers moyens de commutation 14. La deuxième branche résistive comporte dans cet exemple une quatrième résistance 19 de valeur $R_3$. Les deuxièmes moyens de commutation comportent un troisième optocoupleur 10 dont la diode est reliée à une troisième borne de commande 183 du contrôleur 18. Le troisième optocoupleur 10 est relié d'une part au point commun 17 et d'autre part à la quatrième résistance 19.

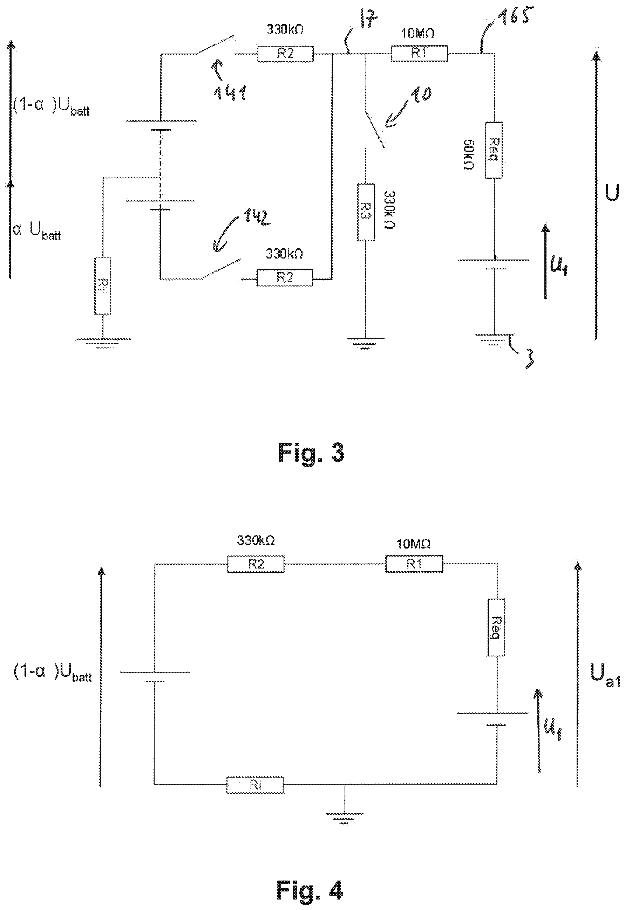

La deuxième et la troisième résistance 162, 163 constituent un diviseur de tension. Cet ensemble avec la borne de référence 184 forme l'équivalent d'une source de tension d'adaptation $U_1=U_0/2$ en série avec une résistance de valeur $R_{eq}=R_5/2$, comme représenté en particulier sur la figure 3.

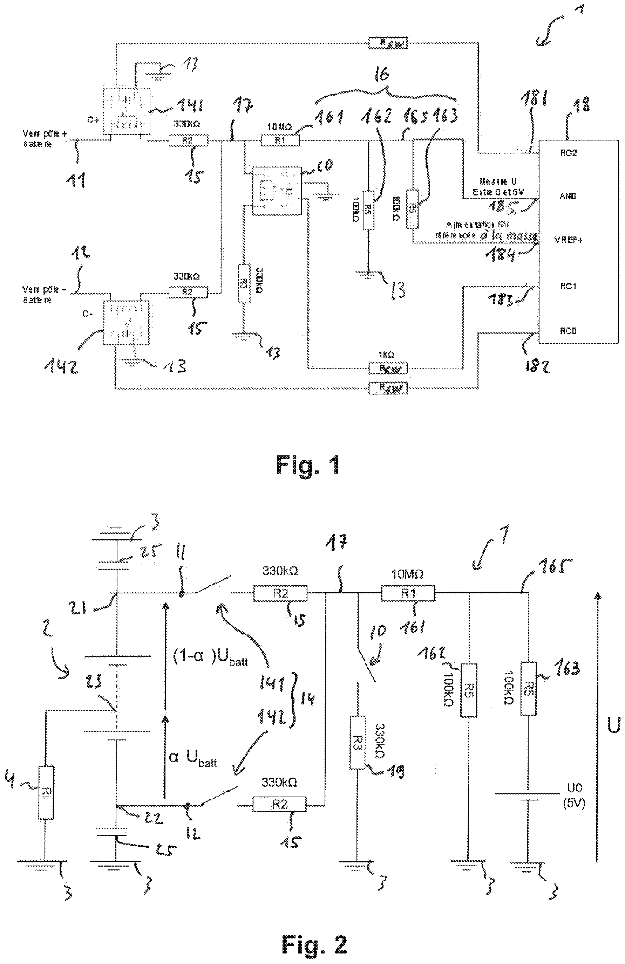

En se référant à la figure 2, le dispositif 1 selon l'invention est utilisé avec une batterie 2 d'accumulateurs délivrant une tension Ubatt entre la deuxième et la première borne 22, 21. La résistance d'isolement entre le circuit de traction et la masse 3 est symbolisée par une résistance d'isolement 4 de valeur Ri connectée dans une position intermédiaire 23 entre des accumulateurs de la batterie 2. La position de la résistance d'isolement 4 est telle que la tension Ubatt est divisée en deux parties, une tension $\alpha U_{batt}$ entre la deuxième borne 12 et la position intermédiaire 23, et $(1- \alpha)U_{batt}$ entre la position intermédiaire 23 et la première borne 21. Le schéma de la figure 2 montre également des condensateurs 25 représentant les capacités de mode commun entre la masse 3 et respectivement la première et la deuxième borne 11, 12. Comme les mesures qui sont réalisées par le dispositif 1 sont des mesures en situation stabilisée, ces capacités ne sont pas prises en compte par la suite. Le dispositif 1 est installé sur le véhicule de manière temporaire ou permanente de telle sorte que le premier connecteur 11 est connecté à la première borne 21, le deuxième connecteur 12 est connecté à la deuxième borne 22 de la batterie 2 et le troisième connecteur 13 est connecté à la masse 3 électrique du véhicule.

**Fonctionnement**

Dans une première étape, le contrôleur 18 pilote les premiers et les deuxièmes moyens de commutation 14, 10 pour que le premier optocoupleur 141 soit passant, le deuxième optocoupleur 142 soit ouvert et troisième optocoupleur 10 soit également ouvert. Dans cette configuration, le circuit équivalent est représenté sur la figure 4 et une première mesure $U_{a1}$ est réalisée par le voltmètre du contrôleur 18. On en déduit l'équation suivante :

$$U_{a1} = \frac{\frac{R_5}{2}}{R_1 + \frac{R_5}{2} + R_2 + R_i}(1-\alpha)U_{batt} + \left(1 - \frac{\frac{R_5}{2}}{R_1 + \frac{R_5}{2} + R_2 + R_i}\right)\frac{U_0}{2}$$

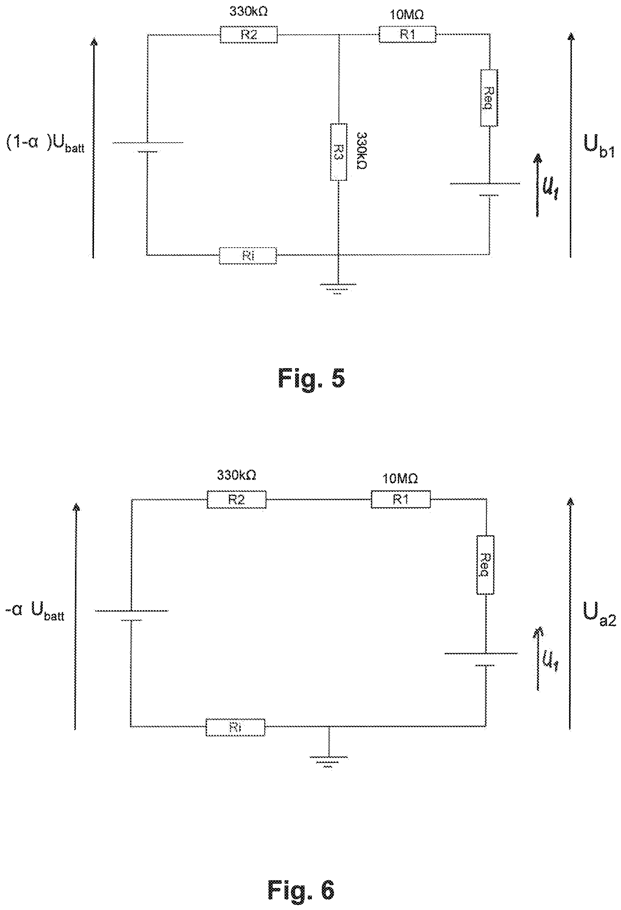

Dans une deuxième étape, le contrôleur 18 pilote les premiers et les deuxièmes moyens de commutation 14, 10 pour que le premier optocoupleur 141 soit ouvert et le deuxième optocoupleur 142 soit passant. Le troisième optocoupleur 10 est également commandé pour être ouvert. Dans cette configuration, le circuit équivalent est représenté sur la figure 6 et une deuxième mesure Ua2 est réalisée par le voltmètre du contrôleur 18. On en déduit l'équation suivante :

$$U_{a2} = \frac{\frac{R_5}{2}}{R_1 + \frac{R_5}{2} + R_2 + R_i} \times (- \alpha \cdot U_{batt}) + \left(1 - \frac{\frac{R_5}{2}}{R_1 + \frac{R_5}{2} + R_2 + R_i}\right)\frac{U_0}{2}$$

Dans une troisième étape, le contrôleur 18 pilote les premiers et les deuxièmes moyens de commutation pour que le premier optocoupleur 141 soit passant, le deuxième optocoupleur 142 soit ouvert et le troisième optocoupleur 10 soit fermé. Dans cette configuration, le circuit équivalent est représenté sur la figure 5 et une troisième mesure Ub1 est réalisée par le voltmètre du contrôleur 18. On en déduit l'équation suivante :

$$U_{b1} = \frac{\frac{R_5}{2}}{R_1 + \frac{R_5}{2} + \frac{R_3(R_2 + R_i)}{R_2 + R_3 + R_i}} \frac{R_3}{R_2 + R_3 + R_i}(1-\alpha)U_{batt} + \left(1 - \frac{\frac{R_5}{2}}{R_1 + \frac{R_5}{2} + \frac{R_3(R_2 + R_i)}{R_2 + R_3 + R_i}}\right)\frac{U_0}{2}$$

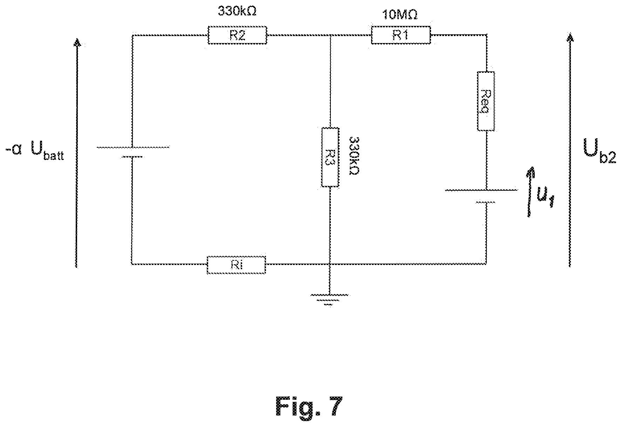

Dans une quatrième étape, le contrôleur 18 pilote les premiers et les deuxièmes moyens de commutation pour que le premier optocoupleur 141 soit ouvert et le deuxième optocoupleur 142 soit passant. Le troisième optocoupleur 10 est commandé pour être fermé. Dans cette configuration, le circuit équivalent est représenté sur la figure 7 et une quatrième mesure $U_{b2}$ est réalisée par le voltmètre du contrôleur 18. On en déduit l'équation suivante :

$$U_{b2} = \frac{\frac{R_5}{2}}{R_1 + \frac{R_5}{2} + \frac{R_3(R_2 + R_i)}{R_2 + R_3 + R_i}} \frac{R_3}{R_2 + R_3 + R_i} \times (-\alpha \cdot U_{batt}) + \left(1 - \frac{\frac{R_5}{2}}{R_1 + \frac{R_5}{2} + \frac{R_3(R_2 + R_i)}{R_2 + R_3 + R_i}}\right)\frac{U_0}{2}$$

En posant

$$k_a = 1 - \frac{\frac{R_5}{2}}{R_1 + \frac{R_5}{2} + R_2 + R_i} \quad \text{et} \quad k_b = 1 - \frac{\frac{R_5}{2}}{R_1 + \frac{R_5}{2} + \frac{R_3(R_2 + R_i)}{R_2 + R_3 + R_i}},$$

$$\begin{cases} U_{a1} = \frac{\frac{R_5}{2}}{R_1 + \frac{R_5}{2} + R_2 + R_i}(1-\alpha)U_{batt} + k_a\frac{U_0}{2} \\[2em] U_{b1} = \frac{\frac{R_5}{2}}{R_1 + \frac{R_5}{2} + \frac{R_3(R_2 + R_i)}{R_2 + R_3 + R_i}}\frac{R_3}{R_2 + R_3 + R_i}(1-\alpha)U_{batt} + k_b\frac{U_0}{2} \end{cases}$$

Estimations de $k_a$ et $k_b$ :

$$1 - \frac{\frac{R_5}{2}}{R_1 + \frac{R_5}{2} + R_2} \leq k_a \leq 1$$

lorsque $R_i$ est respectivement nulle ou tend vers l'infini, et

$$1 - \frac{\dfrac{R_5}{2}}{R_1 + \dfrac{R_5}{2} + \dfrac{R_2 R_3}{R_2 + R_3}} \le k_b \le 1 - \frac{\dfrac{R_5}{2}}{R_1 + \dfrac{R_5}{2} + R_3}$$

lorsque $R_i$ est respectivement nulle ou tend vers l'infini.

Avec les valeurs de $R_1$=10MΩ, $R_2$=330kΩ et $R_5$=100kΩ, $\boxed{0{,}9952 \le k_a \le 1}$ et $\boxed{0.9951 \le k_b \le 0.9952}$

Les valeurs des coefficients $k_a$ et $k_b$ sont proches de 1 du fait que la première résistance $R_1$ est très élevée par rapport aux autres résistances. L'invention est particulièrement intéressante à mettre en oeuvre pour détecter si la résistance d'isolement est proche de la limite réglementaire, donc lorsqu'elle est au plus faible. On fait donc les approximations suivantes : $\boxed{k_a = k_b = 0{,}9952}$

Par la suite, on pose

$$\begin{cases} U_{A1} = U_{a1} - k_a \dfrac{U_0}{2} = U_{a1} - k_a U_1 \\[2mm] U_{B1} = U_{b1} - k_b \dfrac{U_0}{2} = U_{b1} - k_b U_1 \end{cases}$$

On arrive à :

$$\begin{cases} U_{A1} = \dfrac{\dfrac{R_5}{2}}{R_1 + \dfrac{R_5}{2} + R_2 + R_i}(1-\alpha)U_{batt} \\[5mm] U_{B1} = \dfrac{\dfrac{R_5}{2}}{R_1 + \dfrac{R_5}{2} + \dfrac{R_3(R_2 + R_i)}{R_2 + R_3 + R_i}} \dfrac{R_3}{R_2 + R_3 + R_i}(1-\alpha)U_{batt} \end{cases}$$

Si le défaut d'isolement n'est pas sur la première borne 21, 1-α est non nul, et la division des deux équations précédentes (la première par la deuxième) est possible. Elle permet d'éliminer le terme (1-α)$U_{batt}$ et d'exprimer $R_i$ en fonction des résistances du circuit et du ratio $U_{A1}/U_{B1}$ selon l'équation suivante :

$$\boxed{R_i = R_3 \frac{\dfrac{U_{A1}}{U_{B1}}\left(R_1 + R_{eq} + R_2\right) - \left(R_1 + R_{eq}\right)\left(\dfrac{R_2 + R_3}{R_3}\right) - R_2}{R_1 + R_{eq} + R_3\left(1 - \dfrac{U_{A1}}{U_{B1}}\right)}}$$

De la même manière, en posant :

$$\begin{cases} U_{A2} = U_{a2} - k_a \dfrac{U_0}{2} = U_{a2} - k_a U_1 \\ U_{B2} = U_{b2} - k_b \dfrac{U_0}{2} = U_{b2} - k_b U_1 \end{cases}$$

on obtient :

$$R_i = R_3 \dfrac{\dfrac{U_{A2}}{U_{B2}}\left(R_1 + R_{eq} + R_2\right) - \left(R_1 + R_{eq}\right)\left(\dfrac{R_2 + R_3}{R_3}\right) - R_2}{R_1 + R_{eq} + R_3\left(1 - \dfrac{U_{A2}}{U_{B2}}\right)}$$

On dispose ainsi de deux méthodes de détermination de la résistance d'isolement.

Pour déterminer la position du défaut d'isolement, en réalisant le rapport des deux équations exprimant $U_{A1}$ et $U_{A2}$, ou le rapport des deux équations exprimant $U_{B1}$ et $U_{B2}$, on en déduit respectivement :

$$\alpha = \dfrac{1}{1 - \dfrac{U_{A1}}{U_{A2}}} \qquad \text{et} \qquad \alpha = \dfrac{1}{1 - \dfrac{U_{B1}}{U_{B2}}}$$

On dispose ainsi de deux possibilités pour déterminer la position de la résistance d'isolement.

Il existe une configuration dans laquelle ces deux formules ne sont pas utilisables : lorsque $U_{a2}$ et $U_{B2}$ sont nulles. Dans ce cas-là, le défaut est obligatoirement positionné sur le pôle négatif de la batterie ($\alpha = 0$) et il n'y a pas lieu d'utiliser un rapport pour identifier la position du défaut.

Les valeurs estimées de $R_i$ et $\alpha$ peuvent être calculées par le contrôleur 18 et mises à disposition soit d'un utilisateur par l'intermédiaire d'un afficheur, non représenté, soit d'un autre système d'information par l'intermédiaire d'un bus de communication filaire ou sans fil, selon un protocole adapté, dont certains sont déjà connus pour être mis en oeuvre sur un véhicule. On peut également programmer le contrôleur 18 pour générer une alerte lorsque la valeur de la résistance d'isolement est au-dessous d'un seuil prédéterminé.

## Revendications

1. Procédé de détermination de la position d'un défaut d'isolement entre un circuit électrique incluant une batterie (2) d'accumulateurs dans un véhicule automobile et la masse (3) du véhicule, la batterie (2) comportant une première et une deuxième borne (22) pour alimenter le circuit, procédé selon lequel on connecte des moyens de mesure comportant une première branche résistive (16) entre une première borne (21) de la batterie (2) et la masse (3), le procédé étant **caractérisé en ce que**
la première branche résistive (16) comporte deux résistances (161, $R_{eq}$) en série et une source de tension d'adaptation ($U_1$), et on réalise une première mesure représentative du courant dans la première branche résistive (16) par une mesure de tension entre la masse (3) et un point intermédiaire (165) entre les deux résistances (161, $R_{eq}$), et on réalise une deuxième mesure similaire à la première mesure en connectant les moyens de mesure entre la deuxième borne (22) de la batterie (2) et la masse (3), et on déduit des deux mesures une position du défaut d'isolement à l'intérieur de la batterie (2).

2. Procédé de détermination d'au moins une caractéristique d'un défaut d'isolement **caractérisé en ce qu'**on détermine la position du défaut d'isolement par le procédé selon la revendication 1, et on réalise une troisième mesure similaire à la première mesure en connectant en outre une deuxième branche résistive (19) en parallèle à la première branche résistive (16), et on déduit de la première et de la troisième mesure une valeur de la résistance du défaut d'isolement.

3.  Procédé selon la revendication 1 ou 2, selon lequel on place en outre une résistance de protection (15) connectée entre la première branche résistive (16) et la borne de la batterie (2).

4.  Procédé selon l'une des revendications 1 à 3, selon lequel la position de la résistance d'isolement ($R_i$), exprimée par un coefficient de proportion $\alpha$ de tension entre la deuxième et la première borne 21, est calculée par l'expression :

$$\alpha = \frac{1}{1 - \dfrac{U_{A1}}{U_{A2}}}$$

si UA2 non nulle, $\alpha$ = 0 sinon. avec

$$\begin{cases} U_{A1} = U_{a1} - k_a U_1 \\ U_{A2} = U_{a2} - k_a U_1 \end{cases}$$

où $U_{a1}$ et $U_{a2}$ représentent respectivement la première et la deuxième mesure, $k_a$ un coefficient représentatif des moyens de mesure et proche de 1 et $U_1$ la tension d'adaptation.

5.  Procédé selon la revendication 2, dans lequel on réalise en outre une quatrième mesure similaire à la deuxième mesure en connectant la deuxième branche résistive (19) en parallèle à la première branche résistive (16) et pour estimer la valeur de la résistance d'isolement $R_i$ par l'expression :

$$R_i = R_3 \frac{\dfrac{U_{A1}}{U_{B1}} \left( R_1 + R_{eq} + R_2 \right) - \left( R_1 + \dfrac{R_5}{2} \right) \left( \dfrac{R_2 + R_3}{R_3} \right) - R_2}{R_1 + R_{eq} + R_3 \left( 1 - \dfrac{U_{A1}}{U_{B1}} \right)}$$

si $U_{B1}$ est non nulle, ou par l'expression

$$R_i = R_3 \frac{\dfrac{U_{A2}}{U_{B2}} \left( R_1 + R_{eq} + R_2 \right) - \left( R_1 + R_{eq} \right) \left( \dfrac{R_2 + R_3}{R_3} \right) - R_2}{R_1 + R_{eq} + R_3 \left( 1 - \dfrac{U_{A2}}{U_{B2}} \right)}$$

si $U_{B2}$ est non nulle, avec

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

où $U_{a1}$, $U_{a2}$,, $U_{b1}$ et $U_{b2}$ représentent respectivement la première, la deuxième, la troisième mesure et la quatrième

mesure, $k_a$ et $k_b$ des coefficients représentatifs des moyens de mesure et proche de 1, $U_1$ la tension d'adaptation, $R_2$ la valeur de la résistance de protection (15), $R_3$ la valeur de la résistance de la deuxième branche (19), $R_{eq}$ la valeur de la résistance de la première branche (16) entre la masse (3) et le point intermédiaire (165) et $R_1$ la valeur de la résistance (161) de la première branche entre le point intermédiaire (165) et le point de connexion (17) entre la première et la deuxième branche (16, 19).

**6.** Dispositif de détermination de la position d'un défaut d'isolement entre un circuit électrique incluant une batterie (2) d'accumulateurs dans un véhicule automobile et la masse (3) du véhicule, la batterie (2) comportant une première et une deuxième borne (22) pour alimenter le circuit, le dispositif (1) comportant des moyens de mesure comportant une première branche résistive (16) destinée à être connectée entre une première borne (21) de la batterie (2) et la masse (3) et agencés pour réaliser une première mesure représentative du courant dans la première branche résistive (16),
le dispositif étant **caractérisé en ce que**
la première branche résistive (16) comporte deux résistances (161, $R_{eq}$) et une source de tension d'adaptation ($U_1$) en série, les moyens de mesure comportant un voltmètre pour mesurer une tension entre la masse (3) et un point intermédiaire (165) entre les deux résistances (161, $R_{eq}$), et des premiers moyens de commutation (14) pour connecter la deuxième borne (22) de la batterie (2) à la première branche résistive (16), les moyens de mesure étant agencés pour réaliser une deuxième mesure similaire à la première mesure entre la deuxième borne (22) et la masse (3) et pour déduire de la première et de la deuxième mesure une position d'un défaut d'isolement à l'intérieur de la batterie (2).

**7.** Dispositif selon la revendication 6 de détermination d'au moins une caractéristique d'un défaut d'isolement, dans lequel les moyens de mesure comportent en outre une deuxième branche résistive (19) et de deuxièmes moyens de commutation (10) pour connecter sélectivement la deuxième branche résistive (19) en parallèle à la première branche résistive (16) entre la masse (3) et les premiers moyens de commutation (14), le dispositif étant agencé pour réaliser une troisième mesure similaire à la première mesure en connectant la deuxième branche résistive (19) en parallèle à la première branche résistive (16), et pour déduire de la première et de la troisième mesure une valeur de la résistance du défaut d'isolement.

**8.** Dispositif selon la revendication 6 ou 7, dans lequel les moyens de mesure comportent au moins une résistance de protection (15) destinée à être connectée à la borne (21, 22) de la batterie (2).

**9.** Dispositif selon l'une des revendications 6 à 8, dans lequel la position de la résistance d'isolement ($R_i$), exprimée par un coefficient de proportion $\alpha$ de tension entre la deuxième et la première borne 21, est calculée par l'expression :

$$\alpha = \frac{1}{1 - \dfrac{U_{A1}}{U_{A2}}}$$

si UA2 non nulle, $\alpha$ = 0 sinon. avec

$$\begin{cases} U_{A1} = U_{a1} - k_a U_1 \\ U_{A2} = U_{a2} - k_a U_1 \end{cases}$$

où $U_{a1}$ et $U_{a2}$ représentent respectivement la première et la deuxième mesure, $k_a$ un coefficient représentatif des moyens de mesure et proche de 1 et $U_1$ la tension d'adaptation.

**10.** Dispositif selon la revendication 6, dans lequel les moyens de mesure sont agencés pour réaliser en outre une quatrième mesure similaire à la deuxième mesure en connectant la deuxième branche résistive (19) en parallèle à la première branche résistive (16) et pour estimer la valeur de la résistance d'isolement $R_i$ par l'expression

$$R_i = R_3 \frac{\dfrac{U_{A1}}{U_{B1}}\left(R_1 + R_{eq} + R_2\right) - \left(R_1 + \dfrac{R_5}{2}\right)\left(\dfrac{R_2 + R_3}{R_3}\right) - R_2}{R_1 + R_{eq} + R_3\left(1 - \dfrac{U_{A1}}{U_{B1}}\right)}$$

si $U_{B1}$ est non nulle, ou par l'expression

$$R_i = R_3 \frac{\dfrac{U_{A2}}{U_{B2}}\left(R_1 + R_{eq} + R_2\right) - \left(R_1 + R_{eq}\right)\left(\dfrac{R_2 + R_3}{R_3}\right) - R_2}{R_1 + R_{eq} + R_3\left(1 - \dfrac{U_{A2}}{U_{B2}}\right)}$$

si $U_{B2}$ est non nulle, avec

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

où $U_{a1}$, $U_{a2}$,, $U_{b1}$ et $U_{b2}$ représentent respectivement la première, la deuxième, la troisième mesure et la quatrième mesure, $k_a$ et $k_b$ des coefficients représentatifs des moyens de mesure et proche de 1, $U_1$ la tension d'adaptation, $R_2$ la valeur de la résistance de protection (15), $R_3$ la valeur de la résistance de la deuxième branche (19), $R_{eq}$ la valeur de la résistance de la première branche (16) entre la masse (3) et le point intermédiaire (165) et $R_1$ la valeur de la résistance (161) de la première branche entre le point intermédiaire (165) et le point de connexion (17) entre la première et la deuxième branche (16, 19).

**Patentansprüche**

1. Verfahren zur Bestimmung der Position eines Isolationsfehlers zwischen einer elektrischen Schaltung mit einer Batterie (2) aus Akkumulatoren in einem Kraftfahrzeug und der Masse (3) des Fahrzeugs, wobei die Batterie (2) eine erste und zweite Klemme (22) zur Versorgung der Schaltung umfasst, Verfahren, nach dem Messmittel, umfassend einen ersten Widerstandszweig (16) zwischen einer ersten Klemme (21) der Batterie (2) und der Masse (3) verbunden werden, wobei das Verfahren **dadurch gekennzeichnet ist, dass** der erste Widerstandszweig (16) zwei Widerstände (161, $R_{eq}$) in Reihe und eine Anpassungsspannungsquelle ($U_1$) umfasst, und eine erste Messung durchgeführt wird, die den Strom im ersten Widerstandszweig (16) darstellt, indem eine Messung der Spannung zwischen der Masse (3) und einem Zwischenpunkt (165) zwischen den beiden Widerständen (161, $R_{eq}$) durchgeführt wird und eine zweite Messung ähnlich der ersten Messung durch Verbinden der Messmittel zwischen der zweiten Klemme (22) der Batterie (2) und der Masse (3) durchgeführt wird, und aus den beiden Messungen eine Position des Isolationsfehlers innerhalb der Batterie (2) abgeleitet wird.

2. Verfahren zum Bestimmen mindestens einer Eigenschaft eines Isolationsfehlers, **dadurch gekennzeichnet, dass** die Position des Isolationsfehlers durch das Verfahren nach Anspruch 1 bestimmt wird und eine dritte Messung ähnlich der ersten Messung durch weiteres Verbinden eines zweiten Widerstandszweigs (19) parallel zum ersten Widerstandszweig (16) durchgeführt wird und ein Wert des Widerstands des Isolationsfehlers aus der ersten und dritten Messung abgeleitet wird.

3. Verfahren nach Anspruch 1 oder 2, nach dem zusätzlich ein Schutzwiderstand (15) zwischen dem ersten Widerstandszweig (16) und der Batterieklemme (2) angeordnet wird.

4. Verfahren nach einem der Ansprüche 1 bis 3, nach dem die Position des Isolationswiderstands ($R_i$), ausgedrückt durch einen Proportionalitätskoeffizienten $\alpha$ der Spannung zwischen der zweiten und der ersten Klemme 21, durch den folgenden Ausdruck berechnet wird:

$$\propto = \cfrac{1}{1 - \cfrac{U_{A1}}{U_{A2}}}$$

falls UA2 nicht null, andernfalls $\alpha = 0$.
bei

$$\begin{cases} U_{A1} = U_{a1} - k_a U_1 \\ U_{A2} = U_{a2} - k_a U_1 \end{cases}$$

wobei $U_{a1}$ und $U_{a2}$ jeweils die erste und zweite Messung, $k_a$ einen die Messmittel darstellenden Koeffizienten nahe 1 und $U_1$ die Anpassungsspannung darstellen.

5. Verfahren nach Anspruch 2, bei dem auch eine vierte Messung ähnlich der zweiten Messung durchgeführt wird, indem der zweite Widerstandszweig (19) parallel zum ersten Widerstandszweig (16) verbunden wird und um den Wert des Isolationswiderstands $R_i$ durch den folgenden Ausdruck zu schätzten:

$$R_i = R_3 \left| \cfrac{\cfrac{U_{A1}}{U_{B1}}\left(R_1 + R_{eq} + R_2\right) - \left(R_1 + \cfrac{R_5}{2}\right)\left(\cfrac{R_2 + R_3}{R_3}\right) - R_2}{R_1 + R_{eq} + R_3\left(1 - \cfrac{U_{A1}}{U_{B1}}\right)} \right|$$

falls $U_{B1}$ nicht null ist oder durch den Ausdruck

$$R_i = R_3 \left| \cfrac{\cfrac{U_{A2}}{U_{B2}}\left(R_1 + R_{eq} + R_2\right) - \left(R_1 + R_{eq}\right)\left(\cfrac{R_2 + R_3}{R_3}\right) - R_2}{R_1 + R_{eq} + R_3\left(1 - \cfrac{U_{A2}}{U_{B2}}\right)} \right|$$

falls $U_{B2}$ nicht null ist, bei

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

wobei $U_{a1}$, $U_{a2}$, $U_{b1}$ und $U_{b2}$ jeweils die erste, die zweite, die dritte und die vierte Messung, $k_a$ und $k_b$ Messmittel darstellende Koeffizienten nahe 1, $U_1$ die Anpassungsspannung, $R_2$ den Wert des Schutzwiderstands (15), $R_3$ den Wert des Widerstands des zweiten Zweigs (19), $R_{eq}$ den Wert des Widerstands des ersten Zweigs (16) zwischen der Masse (3) und dem Zwischenpunkt (165) und $R_1$ den Wert des Widerstands (161) des ersten Zweigs zwischen dem Zwischenpunkt (165) und dem Verbindungspunkt (17) zwischen dem ersten und dem zweiten Zweig (16, 19) darstellen.

6. Vorrichtung zur Bestimmung der Position eines Isolationsfehlers zwischen einer elektrischen Schaltung mit einer Batterie (2) aus Akkumulatoren in einem Kraftfahrzeug und der Masse (3) des Fahrzeugs, wobei die Batterie (2) eine erste und zweite Klemme (22) zur Versorgung der Schaltung umfasst, wobei die Vorrichtung (1) Messmittel umfasst, die einen ersten Widerstandszweig (16), der dazu bestimmt ist, zwischen einer ersten Klemme (21) der Batterie (2) und der Masse (3) verbunden zu werden, umfassen, und angeordnet sind, um eine erste Messung durchzuführen, die den Strom im ersten Widerstandszweig (16) darstellt, wobei die Vorrichtung **dadurch gekennzeichnet ist, dass** der erste Widerstandszweig (16) zwei Widerstände (161, $R_{eq}$) und eine Anpassungsspannungsquelle ($U_1$) in Reihe umfasst, wobei die Messmittel einen Spannungsmesser zum Messen einer Spannung zwischen der Masse (3) und einem Zwischenpunkt (165) zwischen den beiden Widerständen (161, $R_{eq}$) und erste Schaltmittel (14) zum Verbinden der zweiten Klemme (22) der Batterie (2) mit dem ersten Widerstandszweig (16) umfassen, wobei die Messmittel angeordnet sind, um eine zweite Messung ähnlich der ersten Messung zwischen der zweiten Klemme (22) und der Masse (3) durchzuführen und um aus der ersten und zweiten Messung eine Position eines Isolationsfehlers innerhalb der Batterie (2) abzuleiten.

7. Vorrichtung nach Anspruch 6 zum Bestimmen mindestens einer Eigenschaft eines Isolationsfehlers, wobei die Messmittel ferner einen zweiten Widerstandszweig (19) und zweite Schaltmittel (10) zum selektiven Verbinden des zweiten Widerstandszweigs (19) parallel zum ersten Widerstandszweig (16) zwischen der Masse (3) und den ersten Schaltmitteln (14) umfassen, wobei die Vorrichtung angeordnet ist, um eine dritte Messung ähnlich der ersten Messung durchzuführen, indem sie den zweiten Widerstandszweig (19) parallel zum ersten Widerstandszweig (16) verbindet, und um aus der ersten und dritten Messung einen Wert des Widerstands des Isolationsfehlers abzuleiten.

8. Vorrichtung nach Anspruch 6 oder 7, wobei die Messmittel mindestens einen Schutzwiderstand (15), der dazu bestimmt ist, an die Klemme (21, 22) der Batterie (2) angeschlossen zu werden, umfassen.

9. Vorrichtung nach einem der Ansprüche 6 bis 8, wobei die Position des Isolationswiderstands ($R_i$), ausgedrückt durch einen Proportionalitätskoeffizienten $\alpha$ der Spannung zwischen der zweiten und der ersten Klemme 21, durch den folgenden Ausdruck berechnet wird:

$$\propto = \frac{1}{1 - \dfrac{U_{A1}}{U_{A2}}}$$

falls UA2 nicht null, andernfalls $\alpha = 0$.
bei

$$\begin{cases} U_{A1} = U_{a1} - k_a U_1 \\ U_{A2} = U_{a2} - k_a U_1 \end{cases}$$

wobei $U_{a1}$ und $U_{a2}$ jeweils die erste und zweite Messung, $k_a$ einen die Messmittel darstellenden Koeffizienten nahe 1 und $U_1$ die Anpassungsspannung darstellen.

10. Vorrichtung nach Anspruch 6, wobei die Messmittel angeordnet sind, um auch eine vierte Messung ähnlich der zweiten Messung durchzuführen, indem der zweite Widerstandszweig (19) parallel zum ersten Widerstandszweig (16) verbunden wird und um den Wert des Isolationswiderstands $R_i$ durch den folgenden Ausdruck zu schätzen:

$$R_i = R_3 \frac{\frac{U_{A1}}{U_{B1}}\left(R_1 + R_{eq} + R_2\right) - \left(R_1 + \frac{R_5}{2}\right)\left(\frac{R_2 + R_3}{R_3}\right) - R_2}{R_1 + R_{eq} + R_3\left(1 - \frac{U_{A1}}{U_{B1}}\right)}$$

falls $U_{B1}$ nicht null ist oder durch den Ausdruck

$$R_i = R_3 \frac{\frac{U_{A2}}{U_{B2}}\left(R_1 + R_{eq} + R_2\right) - \left(R_1 + R_{eq}\right)\left(\frac{R_2 + R_3}{R_3}\right) - R_2}{R_1 + R_{eq} + R_3\left(1 - \frac{U_{A2}}{U_{B2}}\right)}$$

falls $U_{B2}$ nicht null ist, bei

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

wobei $U_{a1}$, $U_{a2}$, $U_{b1}$ und $U_{b2}$ jeweils die erste, die zweite, die dritte Messung und die vierte Messung, $k_a$ und $k_b$ die Messmittel darstellenden Koeffizienten nahe 1, $U_1$ die Anpassungsspannung, $R_2$ den Wert des Schutzwiderstands (15), $R_3$ den Wert des Widerstands des zweiten Zweigs (19), $R_{eq}$ den Wert des Widerstands des ersten Zweigs (16) zwischen der Masse (3) und dem Zwischenpunkt (165) und $R_1$ den Wert des Widerstands (161) des ersten Zweigs zwischen dem Zwischenpunkt (165) und dem Verbindungspunkt (17) zwischen dem ersten und dem zweiten Zweig (16, 19) darstellen.

## Claims

1. Method for determining the position of an isolation fault between an electrical circuit including a battery (2) of accumulators in a motor vehicle and the ground (3) of the vehicle, the battery (2) comprising a first and a second terminal (22) for supplying the circuit with power, in which method measuring means comprising a first resistive branch (16) are connected between a first terminal (21) of the battery (2) and ground (3), the method being **characterized in that** the first resistive branch (16) comprises two resistors (161, $R_{eq}$) in series and a matching voltage source ($U_1$), and a first measurement representative of the current in the first resistive branch (16) is carried out via a measurement of voltage between ground (3) and a point (165) intermediate between the two resistors (161, $R_{eq}$), and a second measurement similar to the first measurement is carried out by connecting the measuring means between the second terminal (22) of the battery (2) and ground (3), and a position of the isolation fault in the interior of the battery (2) is deduced from the two measurements.

2. Method for determining at least one characteristic of an isolation fault, **characterized in that** the position of the isolation fault is determined using the method according to Claim 1, and a third measurement similar to the first measurement is carried out by furthermore connecting a second resistive branch (19) in parallel to the first resistive branch (16), and a value of the resistance of the isolation fault is deduced from the first and third measurement.

3. Method according to Claim 1 or 2, wherein a protective resistor (15) is furthermore provided, said resistor being connected between the first resistive branch (16) and the terminal of the battery (2).

4. Method according to one of Claims 1 to 3, wherein the position of the isolation resistance ($R_i$), expressed by a coefficient $\alpha$ of voltage proportion between the second and first terminal 21, is computed using the expression:

$$\alpha = \frac{1}{1 - \dfrac{U_{A1}}{U_{A2}}}$$

if UA2 is non-zero, $\alpha = 0$ otherwise.

with

$$\begin{cases} U_{A1} = U_{a1} - k_a U_1 \\ U_{A2} = U_{a2} - k_a U_1 \end{cases}$$

where $U_{a1}$ and $U_{a2}$ are the first and second measurement, respectively, $k_a$ is a coefficient representative of the measuring means and close to 1 and $U_1$ is the matching voltage.

5. Method according to Claim 2, wherein a fourth measurement similar to the second measurement is furthermore carried out by connecting the second resistive branch (19) in parallel to the first resistive branch (16) and to estimate the value of the isolation resistance $R_i$ using the expression:

$$R_i = R_3 \frac{\dfrac{U_{A1}}{U_{B1}}\left(R_1 + R_{eq} + R_2\right) - \left(R_1 + \dfrac{R_5}{2}\right)\left(\dfrac{R_2 + R_3}{R_3}\right) - R_2}{R_1 + R_{eq} + R_3\left(1 - \dfrac{U_{A1}}{U_{B1}}\right)}$$

if $U_{B1}$ is non-zero, or using the expression

$$R_i = R_3 \frac{\dfrac{U_{A2}}{U_{B2}}\left(R_1 + R_{eq} + R_2\right) - \left(R_1 + R_{eq}\right)\left(\dfrac{R_2 + R_3}{R_3}\right) - R_2}{R_1 + R_{eq} + R_3\left(1 - \dfrac{U_{A2}}{U_{B2}}\right)}$$

if $U_{B2}$ is non-zero, with

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

where $U_{a1}$, $U_{a2}$, $U_{b1}$ and $U_{b2}$ are the first, second, third and fourth measurement, respectively, $k_a$ and $k_b$ are coefficients representative of the measuring means and close to 1, $U_1$ is the matching voltage, $R_2$ is the resistance of the protective resistor (15), $R_3$ the resistance of the resistor of the second branch (19), $R_{eq}$ the resistance of the resistor of the first branch (16) between ground (3) and the intermediate point (165) and $R_1$ is the resistance of the resistor (161) of the first branch between the intermediate point (165) and the point (17) of connection between the first and second branch (16, 19).

6. Device for determining the position of an isolation fault between an electrical circuit including a battery (2) of accumulators in a motor vehicle and the ground (3) of the vehicle, the battery (2) comprising a first and a second terminal (22) for supplying the circuit with power, the device (1) comprising measuring means comprising a first resistive branch (16) intended to be connected between a first terminal (21) of the battery (2) and ground (3) and arranged to carry out a first measurement representative of the current in the first resistive branch (16), the device being **characterized in that** the first resistive branch (16) comprises two resistors (161, $R_{eq}$) and a matching voltage source ($U_1$) in series, the measuring means comprising a voltmeter for measuring a voltage between ground (3) and a point (165) intermediate between the two resistors (161, $R_{eq}$), and first switching means (14) for connecting the second terminal (22) of the battery (2) to the first resistive branch (16), the measuring means being arranged to carry out a second measurement similar to the first measurement between the second terminal (22) and ground (3) and to deduce from the first and second measurement a position of an isolation fault in the interior of the battery (2).

7. Device according to Claim 6 for determining at least one characteristic of an isolation fault, wherein the measuring means furthermore comprise a second resistive branch (19) and second switching means (10) for selectively connecting the second resistive branch (19) in parallel to the first resistive branch (16) between ground (3) and the first switching means (14), the device being arranged to carry out a third measurement similar to the first measurement by connecting the second resistive branch (19) in parallel to the first resistive branch (16), and to deduce from the first and third measurement a value of the resistance of the isolation fault.

8. Device according to Claim 6 or 7, wherein the measuring means comprise at least one protective resistor (15) intended to be connected to the terminal (21, 22) of the battery (2).

9. Device according to one of Claims 6 to 8, wherein the position of the isolation resistance ($R_i$), expressed by a coefficient $\alpha$ of voltage proportion between the second and first terminal 21, is computed using the expression:

$$\alpha = \frac{1}{1 - \dfrac{U_{A1}}{U_{A2}}}$$

if UA2 is non-zero, $\alpha = 0$ otherwise.
with

$$\begin{cases} U_{A1} = U_{a1} - k_a U_1 \\ U_{A2} = U_{a2} - k_a U_1 \end{cases}$$

where $U_{a1}$ and $U_{a2}$ are the first and second measurement, respectively, $k_a$ is a coefficient representative of the measuring means and close to 1 and $U_1$ is the matching voltage.

10. Device according to Claim 6, wherein the measuring means are arranged to furthermore carry out a fourth measurement similar to the second measurement by connecting the second resistive branch (19) in parallel to the first resistive branch (16) and to estimate the value of the isolation resistance $R_i$ using the expression:

$$R_i = R_3 \frac{\dfrac{U_{A1}}{U_{B1}}\left(R_1 + R_{eq} + R_2\right) - \left(R_1 + \dfrac{R_5}{2}\right)\left(\dfrac{R_2 + R_3}{R_3}\right) - R_2}{R_1 + R_{eq} + R_3\left(1 - \dfrac{U_{A1}}{U_{B1}}\right)}$$

if $U_{B1}$ is non-zero, or using the expression

$$R_i = R_3 \frac{\dfrac{U_{A2}}{U_{B2}}\left(R_1 + R_{eq} + R_2\right) - \left(R_1 + R_{eq}\right)\left(\dfrac{R_2 + R_3}{R_3}\right) - R_2}{R_1 + R_{eq} + R_3\left(1 - \dfrac{U_{A2}}{U_{B2}}\right)}$$

if $U_{B2}$ is non-zero, with

$$\begin{cases} U_{A1} = U_{a1} - k_a U_1 \\ U_{B1} = U_{b1} - k_b U_1 \end{cases}$$

$$\begin{cases} U_{A2} = U_{a2} - k_a U_1 \\ U_{B2} = U_{b2} - k_b U_1 \end{cases}$$

where $U_{a1}$, $U_{a2}$, $U_{b1}$ and $U_{b2}$ are the first, second, third and fourth measurement, respectively, $k_a$ and $k_b$ are coefficients representative of the measuring means and close to 1, $U_1$ is the matching voltage, $R_2$ is the resistance of the protective resistor (15), $R_3$ the resistance of the resistor of the second branch (19), $R_{eq}$ the resistance of the resistor of the first branch (16) between ground (3) and the intermediate point (165) and $R_1$ is the resistance of the resistor (161) of the first branch between the intermediate point (165) and the point (17) of connection between the first and second branch (16, 19).

EP 2 901 167 B1

Fig. 1

Fig. 2

18

**Fig. 3**

**Fig. 4**

330kΩ    10MΩ
R2    R1

Req

(1-α )U_batt    R3  330kΩ    u_t    U_b1

Ri

**Fig. 5**

330kΩ    10MΩ
R2    R1

Req

-α U_batt    u_t    U_a2

Ri

**Fig. 6**

Fig. 7

**RÉFÉRENCES CITÉES DANS LA DESCRIPTION**

**Documents brevets cités dans la description**

- US 20050264264 A
- EP 1857825 A1
- EP 1265076 A1